# EUROPEAN PATENT SPECIFICATION

(11) **EP 3 072 742 B1**
(45) Date of publication and mention of the grant of the patent: **18.03.2020**
(21) Application number: 15161048.2
(22) Date of filing: 26.03.2015
(51) Int. Cl.: B60Q 3/20, B64D 11/00, F21Y 115/10

(54) **INTERIOR AIRCRAFT LED LIGHT UNIT AND METHOD OF CALIBRATING AN INTERIOR AIRCRAFT LED LIGHT UNIT**
FLUGZEUGINNENRAUM-LED-BELEUCHTUNGSEINHEIT UND VERFAHREN ZUR KALIBRIERUNG EINER FLUGZEUGINNENRAUM-LED-BELEUCHTUNGSEINHEIT
UNITÉ D'ÉCLAIRAGE À DEL INTÉRIEURE D'AÉRONEF ET PROCÉDÉ D'ÉTALONNAGE D'UNE TELLE UNITÉ

(43) Date of publication of application: 28.09.2016
(73) Proprietor: Goodrich Lighting Systems GmbH, 59557 Lippstadt (DE)
(72) Inventor: Schoen, Christian, 55124 Mainz (DE); Voelkel, Stefan, 57271 Hilchenbach (DE)
(74) Representative: Schmitt-Nilson Schraud Waibel Wohlfrom Patentanwälte Partnerschaft mbB

(56) References cited:
- WO-A1-2009/059097
- WO-A1-2012/167107
- WO-A1-2014/147505
- GB-A- 2 365 108
- US-A- 5 282 091
- US-A1- 2013 038 241
- US-B1- 6 623 142

## Description

The present invention relates to interior aircraft lighting. In particular, it relates to interior aircraft light units employing LED technology.

Almost all modern aircraft, in particular commercial passenger aircraft, have interior lighting. The interior light units of an aircraft serve a variety of different purposes. Cabin illumination light units are provided for a general illumination of the aircraft cabin, allowing the passengers and crew to be aware of their surroundings and to walk around the cabin. Signalling lights, such as exit sign light units, are provided for conveying information to the passengers and crew, such as safety-critical information about the positions of the emergency exits of the aircraft. Further, targeted lighting is provided for a variety of purposes. For example, reading lights allow passengers to individually adapt the illumination of their personal space.

With respect to interior aircraft lighting, the industry is transitioning to LED technology, replacing prior art halogen lights. However, with LEDs often having large production tolerances and, thus, the interior LED light units potentially having a large range of deviations from a desired lighting performance, countermeasures with respect to such deviations are carried out during production of the light units. However, such countermeasures are involving, need substantial production time and/or are not fully satisfactory in terms of accuracy.

WO 2009/059097 A1 discloses a lighting system comprising a generally conical shaped optical housing having a focal point and a light source. The light source, for example, an LED, is disposed in the focal point of the optical housing. A lens surrounds at least a portion of the light source and encloses a cavity aligned with the light source.

US 6 623 142 B1 describes a method and an apparatus for adjusting the spectral characteristics of a light emitting diode (LEDs) by placing a filter in the LEDs light emission path. The filter is printed on the lens of the LED or printed on a cap that is later attached to the LED via ink jet printing or another printing method. The specific ink colors selected for the filter depend on the deviation of each LED from a specified tolerance.

Accordingly, it would be beneficial to provide an interior aircraft LED light unit, whose adaptation to the particular batch of LEDs can be carried out in a simplified manner and which can therefore be produced more quickly than in prior art approaches.

Exemplary embodiments of the invention include an interior aircraft LED light unit comprising at least one LED and a lens cover arranged over the at least one LED, the lens cover having a proximal side facing towards the at least one LED and a distal side forming an outside portion of the interior aircraft LED light unit, with the lens cover being made from a lens cover material exhibiting material-specific light transfer properties. The lens cover comprises a pattern of dots on the distal side, with each of the pattern of dots locally altering the material-specific light transfer properties of the lens cover.

The pattern of dots alters the overall light transfer characteristics of the lens cover. In particular, as compared to the lens cover without dots, i.e. as compared to the lens cover consisting essentially of the lens cover material exhibiting the material-specific light transfer properties, the pattern of dots alter the overall amount of light passed through the lens cover and/or alters the color of at least some of the light passed through the lens cover. In this way, the pattern of dots are an efficient way of adjusting the brightness level and/or the light color of the interior aircraft LED light unit. During production, the pattern of dots may be used to balance a deviation of the light output of the interior aircraft LED light unit from a desired light output, which deviation may for example be the result of LED production tolerances. As the pattern of dots are arranged on the distal side of the lens cover, i.e. on the outside portion of the lens cover, they can be provided thereon at a very late point in time during the production. An altering of the interior structure of the interior aircraft LED light unit is not necessary for achieving the desired adaptation of the light output. Further, as the distal side of the lens cover commonly is a substantially flat surface, it provides an ideal base for the arrangement of the pattern of dots.

With the provision of the pattern of dots, the number of measurement operations during the production of the interior aircraft LED light unit may be reduced, as compared to prior art approaches. This in turn leads to a quicker and more efficient production of the interior aircraft LED light unit. In particular, after having chosen the at least one LED to be used with the interior aircraft LED light unit, one measurement may be carried out for determining an initial lighting performance of the at least one LED. This measurement may be taken with respect to the at least one LED alone or with respect to the at least one LED in combination with the lens cover, and potentially also in combination with a further light filter, which will be described below. On the basis of this one measurement, a deviation of the initial lighting performance from a desired lighting performance may be determined, on the basis of which a suitable pattern of dots may be arranged on the distal side of the lens cover. In this way, a desired lighting performance may be achieved, without having to perform further measurements and without having to change the inside structure of the interior aircraft LED light unit after the measurement. Also, the provision of the suitable pattern of dots may be highly automated, reducing the risk of human error during production, and may allow for a very exact balancing of the measured deviation, because the pattern of dots may be easily adapted to the particular unit under production.

The pattern of dots thus provides for a faster, more convenient, and more accurate production of the interior aircraft LED light unit, as compared to prior art approaches where deviations from desired lighting performances were balanced with additional light filters introduced into the interior of the LED light unit. Such introduction of additional light filters was prone to human error due to the hand-picking of these additional filters and required additional testing/measurements after the introduction of the filter for checking the resulting lighting performance.

The term dots refers to localised irregularities in the distal side of the lens cover. The irregularities may consist of added material, being different from the lens cover material, or of removed material, leading e.g. to internal reflection in the lens cover due to the change in geometry, or of chemically or physically altered portions of the lens cover material. The dots are surface irregularities that have a much larger effect than surface defects that are within the production tolerances of common lens covers. The pattern of dots has a macroscopic effect on the light output by the interior aircraft LED light unit.

According to a further embodiment, the pattern of dots are printed onto the distal side of the lens cover. The printing of the pattern of dots is a particularly convenient way of providing the pattern of dots. Printing does not require highly elaborate manufacturing equipment and can be performed virtually at any point throughout the manufacturing process. In a particular embodiment, the pattern of dots are printed onto the distal side of the lens cover via an inkjet printer. Using an inkjet printer allows for a very convenient and flexible way of providing the pattern of dots with a desired set of properties. In particular, the level of transparency/non-transparency of the dots and/or the color-altering properties of the dots may be controlled via the selection of an appropriate ink. In this way, the selection of the ink and the selection of the particular kind of pattern of the dots provide two degrees of freedom that can be made use of for adapting the light output of the interior aircraft LED light unit in a very flexible manner.

According to a further embodiment, the pattern of dots are a pattern of semi-transparent or non-transparent dots. In this way, the pattern of dots provide for an adaptation of the overall light output of the interior aircraft LED light unit, thus reducing the brightness of the interior aircraft LED light unit as compared to the light output in the absence of the pattern of dots. The semi-transparent or non-transparent dots are a way of preventing a certain portion of the light, emitted by the at least one LED, from exiting the interior aircraft LED light unit. Semi-transparent dots alter the material-specific light transfer properties of the lens cover in such a way that they locally only allow for a portion of the light to pass. Non-transparent dots, also refer to as opaque dots, block at least substantially all of the light arriving at those dots from the at least one LED.

According to a further embodiment, the pattern of dots are white-colored dots, when seen from outside of the interior aircraft LED light unit. Dots that appear white from the outside of the interior aircraft LED light unit are particularly beneficial in the context of whitish lens covers, because an observer of the interior aircraft LED light unit cannot see the dots, even when the interior LED light unit is switched off. In other words, the white-colored dots may blend in well with the appearance of common lens covers, thus reaching the desired altering of the light output of the interior aircraft LED light unit without compromising the uniform appearance of the light unit. In a particular embodiment, the pattern of dots may be provided from white, opaque ink.

According to a further embodiment, not forming part of the present invention, the pattern of dots are colored dots altering a color of the light passing through the pattern of dots. In particular, the pattern of dots may be a pattern of semi-transparent dots, passing color of certain wavelengths through the dots and blocking light of other wavelengths. In this way, the pattern of dots act as a color filter, thereby altering the overall color output by the interior aircraft LED light unit.

According to a further embodiment, the pattern of dots are lasered into the distal side of the lens cover. Lasering is an alternative technique for providing dots on the distal side of the lens cover that alters the material-specific light transfer properties of the lens cover. In particular, semi-transparent or fully opaque surface portions of the lens cover may be achieved via lasering. This technique allows for very accurate positioning and confining of the dots.

According to a further embodiment, the pattern of dots is a regular pattern of dots. The term regular pattern of dots refers to a repetitive pattern of dots. In particular, dots may be provided in an equidistant manner along any given direction of the distal side of the lens cover. In this way, the altering of the light output of the interior aircraft LED light unit by the pattern of dots may by identical in the different parts of the distal side of the lens cover. In other words, the altering of the light intensity distribution by the lens cover may be equally distributed across the entire surface thereof.

According to an alternative embodiment, the pattern of dots is a random pattern of dots. The random pattern of dots may reach the desired altering of the light output in a statistical manner. In particular, the random pattern of dots may be a pattern of dots that results from a uniform probability distribution. In other words, the distal side of the lens cover may be split up into a large number of comparably very small discrete positions. For each of these discrete positions, it may be decided on the basis of a particular probability whether this discrete position is provided with a dot or not. The result of this operation is a random pattern of dots, stemming from a uniform probability distribution.

According to a further embodiment, each of the pattern of dots has a size of less than 3 mm, in particular a size of less than 2 mm, further in particular a size of less than 1 mm. In this way, the individual dots are small enough to be not discernable by the human eye for a common illumination level by the at least one LED and a common distance between the observer and the interior aircraft LED light unit. The term size refers to the direction of largest extension of the dots. If the dots are substantially circular in shape, the term size refers to the diameter thereof. If the dots are substantially rectangular or quadratic in shape, the term size refers to the diagonal thereof. In general, the dots may have a variety of different shapes, such as circular, oval, quadratic, rectangular, triangular or other regular shapes. It is also possible that the dots have irregular shapes.

According to a further embodiment, the pattern of dots covers between 10% and 40%, in particular between 15% and 30%, of the distal side of the lens cover. This range of coverage has been found to be a good compromise between effectively balancing production tolerances of the at least one LED, providing for an energy-efficient interior aircraft LED light unit and not adversely effecting the uniform appearance of the interior aircraft LED light unit in an unacceptable manner. In particular, it has been found that this range of coverage allows for the remainder of the interior aircraft LED light unit, i.e. for the at least one LED, the lens cover, and - if applicable - one or more additional light filter(s), to be provided with a nominal light output that is somewhat above the desired brightness and for an effective balancing of this over-performance. With common production tolerances, the desired brightness may then be achieved for a large range of selections of LEDs, leading to an overall high production yield.

According to a further embodiment, the interior aircraft LED light unit further comprises a brightness filter or a color filter, or a combined brightness and color filter or combinations thereof. Said filter may be arranged between the at least one LED and the lens cover. In this way, an initial conditioning of the light output may be achieved via said filter, with the pattern of dots being provided for the fine-tuning of the light output. In this way, production is further simplified in that only one kind of light filter may be used for a particular kind of interior aircraft LED light unit, which light filter brings the light output close to the desired light output. The pattern of dots then leads to a very good convergence towards the desired light output, without requiring much impact on the light unit.

The interior aircraft LED light unit may be an exit sign light unit or a cabin illumination light unit or a reading light unit. It is also possible that the interior aircraft LED light unit is adapted to a variety of other purposes within the aircraft.

Further exemplary embodiments of the invention include an aircraft, such as a rotorcraft or an air plane, comprising at least one interior aircraft LED light unit, as described in any of the embodiments above, arranged on an inside of the aircraft. The features, modifications and advantages, described above with respect to the interior aircraft LED light unit, equally apply to the aircraft having one or more interior aircraft LED light unit(s).

Further exemplary embodiments include a method of calibrating an interior aircraft LED light unit having at least one LED and a lens cover arranged over the at least one LED, the lens cover having a proximal side facing towards the at least one LED and a distal side forming an outside portion of the interior aircraft LED light unit, with the lens cover being made from a lens cover material exhibiting material-specific light transfer properties. The method comprises the steps of measuring an initial lighting performance of the interior aircraft LED light unit and, depending on said step of measuring the initial lighting performance, providing the distal side of the lens cover with a pattern of dots, with each of the pattern of dots locally altering the material-specific light transfer properties of the lens cover.

This method allows for a quick and convenient calibration of the interior aircraft LED light unit to achieve a desired light output. On the basis of an initial lighting performance, i.e. on the basis of a measurement of the lighting performance without the pattern of dots, a suitable pattern of dots may be selected, with each of the dots altering the light output locally, such that an overall light output of the interior aircraft LED light unit is as desired. In particular, cumbersome steps like multiple measurements and introduction of additional color and/or brightness filters as a response to these measurements can be dispensed with. The features, modifications and advantages, described above with respect to the interior aircraft LED light unit, equally apply to the method of calibrating the interior aircraft LED light unit, resulting in analogous method steps.

According to a further embodiment, the step of measuring the initial lighting performance of the interior aircraft LED light unit comprises the step of measuring a light output of the at least one LED without the lens cover. In this way, the light output of the at least one LED may be directly measured, receiving immediate information about the performance of the at least one LED with respect to the production tolerances thereof. In an alternative embodiment, the step of measuring the initial lighting performance of the interior aircraft LED light unit comprises the step of measuring a light output of the interior aircraft LED light unit from an outside of the lens cover. In this way, the light output may be measured in an assembled state at a later stage of the production, with the measurement reflecting the characteristics of the particular at least one LED, of the additional light filter, if present, and of the lens cover. In this way, the production tolerances of all of these components may be recorded as a joined value via one single measurement.

According to a further embodiment, the step of providing the distal side of the lens cover with the pattern of dots comprises the steps of determining a deviation of the initial lighting performance from a desired lighting performance and selecting a density of the pattern of dots in such a way as to compensate for the deviation. In this way, the desired light output of the interior aircraft LED light unit may be achieved accurately via a balancing of the deviation from a desired light output.

Further exemplary embodiments of the invention will be described with respect to the accompanying Figures, wherein:
- Fig. 1: shows two exemplary embodiments of interior aircraft LED light units in accordance with the invention; and
- Fig. 2: shows various exemplary patterns of dots to be used in exemplary embodiments of interior aircraft LED light units in accordance with the invention.

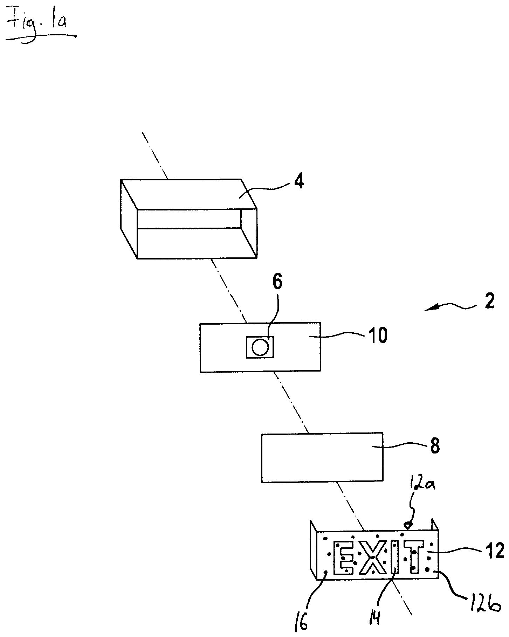

Fig. 1a shows an interior aircraft LED light unit 2 in accordance with an exemplary embodiment of the invention. The interior aircraft LED light unit 2 is shown in an exploded view, such that the individual elements can be seen better.

The interior aircraft LED light unit 2 comprises a housing 4, a mounting plate 10, to which an LED 6 is mounted, a brightness filter 8, and a lens cover 12. The housing 4 is a generally cuboid structure in the exemplary embodiment of Fig. 1a. The mounting plate 10 has a generally planar front surface, and the LED 6 is mounted to substantially the center of the mounting plate 10. When assembled, the mounting plate 10 is positioned towards the back of the housing 4. The brightness filter 8 is a generally planar structure, whose size is fitted to match the size of the lens cover 12 and which is positioned adjacent to the lens cover 12 in the assembled state.

The lens cover 12 has a generally flat front portion and two side portions, with which the lens cover 12 is clipped onto the housing 4 during the assembly. The lens cover 12 has a proximal side 12a that faces towards the brightness filter 8 and towards the mounting plate 10, carrying the LED 6. The proximal side 12a is the back side of the lens cover in the viewing direction of Fig. 1a and can therefore not be seen in the viewing direction of Fig. 1a. Further, the lens cover 12 has a distal side 12b, which forms a portion of the outside of the interior aircraft LED light unit 2 and which forms a light emission surface of the interior aircraft LED light unit 2.

The lens cover 12 is made of a generally transparent, whitish material. In particular, the lens cover may be made of a milk glass material that allows for a large amount of light to be passed through, but prevents the inside of the interior aircraft LED light unit 2 from being visible to the outside environment.

The distal side 12b of the lens cover 12 is provided with a pattern of dots 16. The pattern of dots 16 is a random pattern of dots, distributed over the entire distal side 12b of the lens cover 12. In the exemplary embodiment of Fig. 1a, the dots 16 are black ink dots that prevent the light from the LED 6 to pass through the lens cover 12 at the local positions of the dots 16. It is pointed out that Fig. 1a is not to scale and that the size of the dots 16 may be a lot smaller in comparison with the extension of the lens cover 12. Smaller dots may be chosen, because they are not as easily discernable by the human eye.

Irrespective of the size of the dots 16, the principle of the altering of the light output via the pattern of dots 16 may be seen from the embodiment of Fig. 1a. By blocking a certain portion of light from the LED 6, the overall light output of the interior aircraft LED light unit 2 may be conditioned in such a way that it corresponds to a desired light output. In other words, while the light output of the interior aircraft LED light unit 2 would be above a desired light output in the absence of the pattern of dots 16, the dots 16 decrease the overall brightness of the interior aircraft LED light unit 2 and thus provides for the brightness to be at a desired level.

It is pointed out that the dots 16 do not have to be black dots. The dots 16 may be of different colors, as long as they have the desired effect on the altering of the light output of the interior aircraft LED light unit 2. In a particular embodiment, the dots 16 may be white ink dots.

In the exemplary embodiment of Fig. 1a, the interior aircraft LED light unit 2 is a exit sign light unit. For this purpose, the distal side 12b of the lens cover 12 is provided with the word EXIT 14, which is made from a red transparent material layer. In other words, an additional layer 14, having the shape of the word EXIT, is applied to the distal side 12b of the lens cover 12. This additional layer 14 acts as a localised color filter. As can be seen from Fig. 1a, the locations of the individual letters of the words EXIT 14 coincide with some of the locations of the dots 16. The locations of the letters of the word EXIT 14 and the location of the dots 16 may be chosen independently from each other.

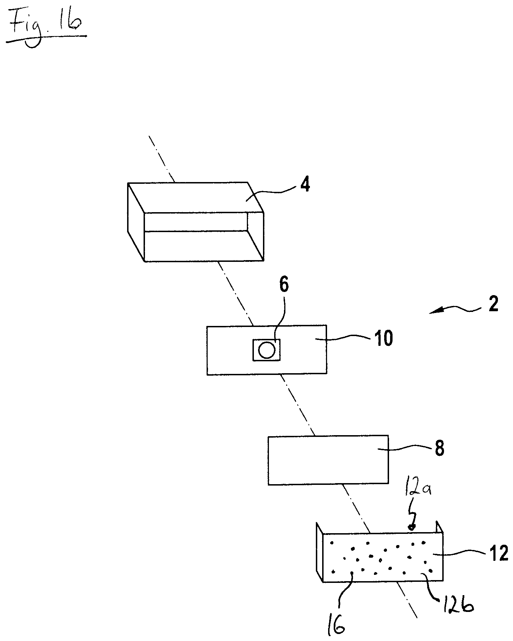

Fig. 1b shows an interior aircraft LED light unit 2 in accordance with another exemplary embodiment of the invention, with the interior aircraft LED light unit 2 being shown in an exploded view as well. The interior aircraft LED light unit 2 of Fig. 1b corresponds to the interior aircraft LED light unit 2 of Fig. 1a, with the exception of the word EXIT 14 being omitted. In this way, the interior aircraft LED light unit 2 of Fig. 1b does not convey any signalling information. It rather serves a general illumination purpose and is provided as a cabin illumination light unit. Again, the pattern of dots 16 is a random pattern of dots distributed over the distal side 12b of the lens cover 12.

A method of calibrating the interior aircraft LED light unit 2 of Fig. 1b, which takes place during the manufacturing of the interior aircraft LED light unit 2, will be described as follows. During the design phase of a particular kind of interior aircraft LED light unit 2, a desired lighting performance, also referred to as a desired light output, may be defined. This desired lighting performance may be defined in terms of various parameters, such as the brightness of the interior aircraft LED light unit 2 and the color of the light output of the interior aircraft LED light unit 2. For the following example, the case of a desired level of brightness will be looked at. The case of a particular color of the light output being achieved is analogous and results in analogous method steps during the calibration. The desired brightness may be given in terms of the light intensity in certain angular ranges or in terms of the luminous flux at the lens cover or at a certain distance therefrom or in terms of any other suitable physical parameter.

During the design phase of the particular kind of interior aircraft LED light unit 2, the LED 6 and the brightness filter 8 may be chosen in such a way that the LED 6, in combination with the chosen brightness filter 8, provides for a light output of 120% of the desired light output. It is possible to choose an LED 6 that has exactly those 120% of the desired light output and to omit the brightness filter 8. However, there may also be instances where an LED with a different level of light output, such as 140% of the desired light output, may be better in terms of performance and/or energy-efficiency, such that the combination of such an LED with a suitable brightness filter 8 may be chosen.

After choosing the LED 6 and the brightness filter 8 in this manner, the mounting plate 10, carrying the LED 6, the brightness filter 8, and the lens cover 12, at this point in time not carrying any pattern of dots, are assembled. The light output of this combination is then measured. With the lens cover 12 passing substantially all of the light therethrough, the nominal light output of this assembly is 120% of the desired light output. However, due to manufacturing tolerances, in particular with respect to the LED 6, an actual light output of this assembly usually differs from the nominal light output. This actual light output is measured and is referred to as the initial lighting performance of the interior aircraft LED light unit 2. In other words, the initial lighting performance is the lighting performance of the interior aircraft LED light unit in the absence of the pattern of dots.

In a particular example, the LED 6 is stronger than its nominal performance, such that the initial lighting performance is 125% of the desired lighting performance. Accordingly, the deviation between the initial lighting performance and the desired lighting performance is 25%. In order to balance this deviation, a pattern of dots 16 is chosen that covers 20% of the distal side 12b of the lens cover 12. In this way, the operating lighting performance of the interior aircraft LED light unit 2 is then 100% of the desired lighting performance, i.e. the operating lighting performance equals the desired lighting performance.

It is pointed out that the nominal lighting performance may be chosen to be above the desired lighting performance on purpose, because cases where the LED has a lower light output than its nominal light output can still be balanced by a suitable pattern of dots 16.

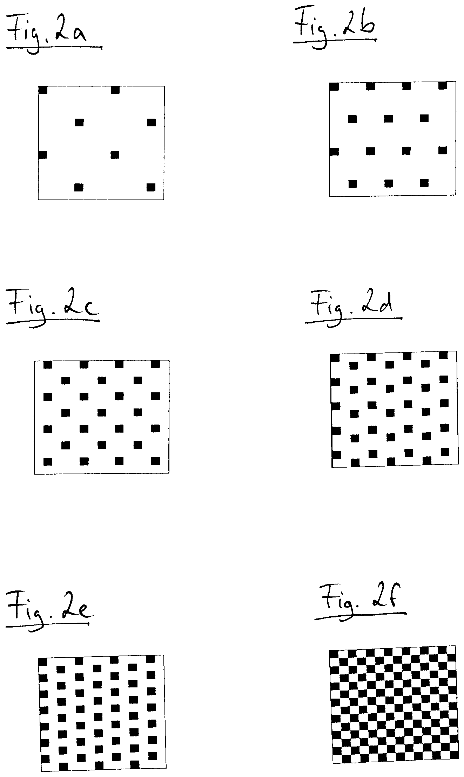

Fig. 2 shows various patterns of dots that can be used for being applied to the distal side 12b of the lens cover 12 of the interior aircraft LED light unit 2 in accordance with exemplary embodiments of the invention. It is pointed out that the different patterns of Fig. 2 are not to scale and that the shown patterns do not correspond to the entire extent of the distal surface 12b of the lens cover 12. Rather, the patterns of Fig. 2 are excerpts of distal surfaces 12b of the lens covers 12 of different interior aircraft LED light units 2.

The patterns of Fig. 2 differ with respect to the level of coverage of the distal side of the lens cover. While differing in coverage, the depicted patterns are all regular patterns, i.e. repetitive patterns, and all have dots of square shape, printed in black ink. The pattern of dots of Fig. 2a is a very scarce pattern of dots, wherein the pattern of dots covers only about 3% of the distal surface of the lens cover. Fig. 2b depicts a fairly scarce pattern of dots, covering about 6% of the distal surface of the lens cover. Fig. 2c depicts a pattern of dots that covers about 12.5% of the distal side of the lens cover. Fig. 2d depicts a denser pattern of dots that covers about 17% of the distal side of the lens cover. Fig. 2e depicts an even denser pattern of dots that covers about 25% of the distal side of the lens cover. Finally, Fig. 2f depicts a yet denser pattern of dots that covers about 50% of the distal side of the lens cover.

As discussed in detail above, the density of the pattern of dots may differ in a wide range, and the number, transparency, nature and shape of the dots may vary depending on the particular application.

While the invention has been described with reference to exemplary embodiments, it will be understood by those skilled in the art that various changes may be made and equivalents may be substituted for elements thereof without departing from the scope of the invention. In addition many modifications may be made to adopt a particular situation or material to the teachings of the invention without departing from the essential scope thereof. Therefore, it is intended that the invention not be limited to the particular embodiment disclosed, but that the invention include all embodiments falling within the scope of the following claims.

## Claims

1. Interior aircraft LED light unit (2), comprising:
at least one LED (6), and
a lens cover (12) arranged over the at least one LED (6), the lens cover (12) having a proximal side (12a) facing towards the at least one LED (6) and a distal side (12b) forming an outside portion of the interior aircraft LED light unit (2), with the lens cover (12) being made from a lens cover material exhibiting material-specific light transfer properties,
**characterized in that** the lens cover (12) comprises a pattern of dots (16) on the distal side (12b), with each of the pattern of dots (16) locally altering the material-specific light transfer properties of the lens cover (12), wherein the pattern of dots (16) are white dots, when seen from outside of the interior aircraft LED light unit (2), and
further **characterized in that** the interior aircraft LED light unit (2) further comprises at least one of a brightness filter (8), a color filter and a combined brightness and color filter, arranged between the at least one LED (6) and the lens cover (12).

2. Interior aircraft LED light unit (2) according to claim 1, wherein the pattern of dots (16) are printed onto the distal side (12b) of the lens cover (12), in particular printed via an inkjet printer.

3. Interior aircraft LED light unit (2) according to claim 1 or 2, wherein the pattern of dots (16) are a pattern of semi-transparent or non-transparent dots.

4. Interior aircraft LED light unit (2) according to any of the preceding claims, wherein the pattern of dots (16) is a regular pattern of dots.

5. Interior aircraft LED light unit (2) according to any of claims 1 to 3, wherein the pattern of dots (16) is a random pattern of dots, with the random pattern of dots in particular resulting from a uniform probability distribution.

6. Interior aircraft LED light unit (2) according to any of the preceding claims, wherein each of the pattern of dots (16) has a size of less than 3mm.

7. Interior aircraft LED light unit (2) according to any of the preceding claims, wherein the pattern of dots (16) covers between 10% and 40%, in particular between 15% and 30%, of the distal side (12b) of the lens cover (12).

8. Interior aircraft LED light unit (2) according to any of the preceding claims, configured as one of an exit sign light unit, a cabin illumination light unit, and a reading light unit.

9. Aircraft, such as a rotorcraft or an air plane, comprising at least one interior aircraft LED light unit (2) according to any of the preceding claims, arranged on an inside of the aircraft.

10. Method of calibrating an interior aircraft LED light unit (2) having at least one LED (6) and a lens cover (12) arranged over the at least one LED (6), the lens cover (12) having a proximal side (12a) facing towards the at least one LED (6) and a distal side (12b) forming an outside portion of the interior aircraft LED light unit (2), with the lens cover (12) being made from a lens cover material exhibiting material-specific light transfer properties and with the interior aircraft LED light unit (2) comprising at least one of a brightness filter (8), a color filter and a combined brightness and color filter, arranged between the at least one LED (6) and the lens cover (12), the method comprising the steps of: measuring an initial lighting performance of the interior aircraft LED light unit (2), and depending on said step of measuring the initial lighting performance, providing the distal side (12b) of the lens cover (12) with a pattern of dots (16), with each of the pattern of dots (16) locally altering the material-specific light transfer properties of the lens cover (12), wherein the pattern of dots (16) are white dots, when seen from outside of the interior aircraft LED light unit (2).

11. Method according to claim 10, wherein the step of providing the distal side (12b) of the lens cover (12) with the pattern of dots (16) comprises:
determining a deviation of the initial lighting performance from a desired lighting performance, and
selecting a density of the pattern of dots (16) in such a way as to compensate for the deviation.

## Patentansprüche

1. Luftfahrzeuginnenraum-LED-Beleuchtungseinheit (2), umfassend:
mindestens eine LED (6), und
eine lichtdurchlässige Abdeckung (12), die über der mindestens einen LED (6) angeordnet ist, wobei die lichtdurchlässige Abdeckung (12) eine proximale Seite (12a), die der mindestens einen LED (6) zugewandt ist, und eine distale Seite (12b), die einen Außenbereich der Luftfahrzeuginnenraum-LED-Beleuchtungseinheit (2) bildet, aufweist, wobei die lichtdurchlässige Abdeckung (12) aus einem Material für die lichtdurchlässige Abdeckung hergestellt ist, das materialspezifische Lichtdurchlässigkeitseigenschaften besitzt,
**dadurch gekennzeichnet, dass** die lichtdurchlässige Abdeckung (12) ein Muster aus Punkten (16) auf der distalen Seite (12b) umfasst, wobei jeder aus dem Muster aus Punkten (16) die materialspezifischen Lichtdurchlässigkeitseigenschaften der lichtdurchlässigen Abdeckung (12) lokal verändert, wobei das Muster aus Punkten (16) weiße Punkte sind, wenn sie von außerhalb der Luftfahrzeuginnenraum-LED-Beleuchtungseinheit (2) gesehen werden, und
ferner **dadurch gekennzeichnet, dass** die Luftfahrzeuginnenraum-LED-Beleuchtungseinheit (2) ferner mindestens einen aus einem Helligkeitsfilter (8), einem Farbfilter und einem kombinierten Helligkeits- und Farbfilter umfasst, der zwischen der mindestens einen LED (6) und der lichtdurchlässigen Abdeckung (12) angeordnet ist.

2. Luftfahrzeuginnenraum-LED-Beleuchtungseinheit (2) nach Anspruch 1, wobei das Muster aus Punkten (16) auf die distale Seite (12b) der lichtdurchlässigen Abdeckung (12) gedruckt ist, insbesondere mittels eines Tintenstrahldruckers gedruckt ist.

3. Luftfahrzeuginnenraum-LED-Beleuchtungseinheit (2) nach Anspruch 1 oder 2, wobei das Muster aus Punkten (16) ein Muster aus halbtransparenten oder nicht transparenten Punkten ist.

4. Luftfahrzeuginnenraum-LED-Beleuchtungseinheit (2) nach einem der vorstehenden Ansprüche, wobei das Muster aus Punkten (16) ein regelmäßiges Muster aus Punkten ist.

5. Luftfahrzeuginnenraum-LED-Beleuchtungseinheit (2) nach einem der Ansprüche 1 bis 3, wobei das Muster aus Punkten (16) ein zufälliges Muster aus Punkten ist, wobei das zufällige Muster aus Punkten insbesondere aus einer gleichförmigen Wahrscheinlichkeitsverteilung resultiert.

6. Luftfahrzeuginnenraum-LED-Beleuchtungseinheit (2) nach einem der vorstehenden Ansprüche, wobei jeder aus dem Muster aus Punkten (16) eine Größe von weniger als 3 mm aufweist.

7. Luftfahrzeuginnenraum-LED-Beleuchtungseinheit (2) nach einem der vorstehenden Ansprüche, wobei das Muster aus Punkten (16) zwischen 10 % und 40 %, insbesondere zwischen 15 % und 30 %, der distalen Seite (12b) der lichtdurchlässigen Abdeckung (12) bedeckt.

8. Luftfahrzeuginnenraum-LED-Beleuchtungseinheit (2) nach einem der vorstehenden Ansprüche, konfiguriert als eine aus einer Ausgangsschildbeleuchtungseinheit, einer Kabinenbeleuchtungseinheit und einer Leseleuchteneinheit.

9. Luftfahrzeug, wie ein Drehflügler oder ein Flugzeug, umfassend mindestens eine Luftfahrzeuginnenraum-LED-Beleuchtungseinheit (2) nach einem der vorstehenden Ansprüche, die an einer Innenseite des Luftfahrzeugs angeordnet ist.

10. Verfahren zum Kalibrieren einer Luftfahrzeuginnenraum-LED-Beleuchtungseinheit (2), die mindestens eine LED (6) und eine lichtdurchlässige Abdeckung (12) aufweist, die über der mindestens einen LED (6) angeordnet ist, wobei die lichtdurchlässige Abdeckung (12) eine proximale Seite (12a), die der mindestens einen LED (6) zugewandt ist, und eine distale Seite (12b), die einen Außenbereich der Luftfahrzeuginnenraum-LED-Beleuchtungseinheit (2) bildet, aufweist, wobei die lichtdurchlässige Abdeckung (12) aus einem Material für die lichtdurchlässige Abdeckung hergestellt ist, das materialspezifische Lichtdurchlässigkeitseigenschaften besitzt, und wobei die Luftfahrzeuginnenraum-LED-Beleuchtungseinheit (2) mindestens einen aus einem Helligkeitsfilter (8), einem Farbfilter und einem kombinierten Helligkeits- und Farbfilter umfasst, der zwischen der mindestens einen LED (6) und der lichtdurchlässigen Abdeckung (12) angeordnet ist, wobei das Verfahren die folgenden Schritte umfasst:
Messen eines anfänglichen Beleuchtungsverhaltens der Luftfahrzeuginnenraum-LED-Beleuchtungseinheit (2), und
abhängig von dem Schritt des Messens des anfänglichen Beleuchtungsverhaltens, Versehen der distalen Seite (12b) der lichtdurchlässigen Abdeckung (12) mit einem Muster aus Punkten (16), wobei jeder aus dem Muster aus Punkten (16) die materialspezifischen Lichtdurchlässigkeitseigenschaften der lichtdurchlässigen Abdeckung (12) lokal verändert, wobei das Muster aus Punkten (16) weiße Punkte sind, wenn sie von außerhalb der Luftfahrzeuginnenraum-LED-Beleuchtungseinheit (2) gesehen werden.

11. Verfahren nach Anspruch 10, wobei der Schritt des Versehens der distalen Seite (12b) der lichtdurchlässigen Abdeckung (12) mit einem Muster aus Punkten (16) Folgendes umfasst:
Ermitteln einer Abweichung des anfänglichen Beleuchtungsverhaltens von einem erwünschten Beleuchtungsverhalten, und
Auswählen einer Dichte des Musters aus Punkten (16) derart, so dass die Abweichung ausgeglichen wird.

## Revendications

1. Unité d'éclairage à DEL intérieure d'aéronef (2), comprenant :
au moins une DEL (6), et
un couvre-lentille (12) disposé sur l'au moins une DEL (6), le couvre-lentille (12) ayant un côté proximal (12a) tourné vers l'au moins une DEL (6) et un côté distal (12b) formant une partie extérieure de l'unité d'éclairage à DEL intérieure d'aéronef (2), le couvre-lentille (12) étant fabriqué à partir d'un matériau de couvre-lentille présentant des propriétés de transfert de lumière spécifiques au matériau,
**caractérisée en ce que** le couvre-lentille (12) comprend un motif de points (16) sur le côté distal (12b), chacun des motifs de points (16) modifiant localement les propriétés de transfert de lumière spécifiques au matériau du couvre-lentille (12), dans lequel le motif de points (16) consiste en des points blancs, lorsqu'ils sont vus de l'extérieur de l'unité d'éclairage à DEL intérieure d'aéronef (2), et
**caractérisée en outre en ce que** l'unité d'éclairage à DEL intérieure d'aéronef (2) comprend en outre au moins l'un d'un filtre de luminosité (8), d'un filtre de couleur et d'un filtre combiné de luminosité et de couleur, disposés entre l'au moins une DEL (6) et le couvre-lentille (12).

2. Unité d'éclairage à DEL intérieure d'aéronef (2) selon la revendication 1, dans laquelle le motif de points (16) est imprimé sur le côté distal (12b) du couvre-lentille (12), en particulier imprimé par l'intermédiaire d'une imprimante à jet d'encre.

3. Unité d'éclairage à DEL intérieure d'aéronef (2) selon la revendication 1 ou 2, dans laquelle le motif de points (16) est un motif de points semi-transparents ou non transparents.

4. Unité d'éclairage à DEL intérieure d'aéronef (2) selon l'une quelconque des revendications précédentes, dans laquelle le motif de points (16) est un motif régulier de points.

5. Unité d'éclairage à DEL intérieure d'aéronef (2) selon l'une quelconque des revendications 1 à 3, dans laquelle le motif de points (16) est un motif aléatoire de points, le motif aléatoire de points résultant en particulier d'une distribution de probabilité uniforme.

6. Unité d'éclairage à DEL intérieure d'aéronef (2) selon l'une quelconque des revendications précédentes, dans laquelle chacun des motifs de points (16) a une taille inférieure à 3 mm.

7. Unité d'éclairage à DEL intérieure d'aéronef (2) selon l'une quelconque des revendications précédentes, dans laquelle le motif de points (16) couvre entre 10 % et 40 %, en particulier entre 15 % et 30 %, du côté distal (12b) du couvre-lentille (12).

8. Unité d'éclairage à DEL intérieure d'aéronef (2) selon l'une quelconque des revendications précédentes, configurée comme l'une d'une unité d'éclairage de panneau de sortie, d'une unité d'éclairage d'illumination de cabine et d'une unité d'éclairage de lecture.

9. Aéronef, tel qu'un giravion ou un avion, comprenant au moins une unité d'éclairage à DEL intérieure d'aéronef (2) selon l'une quelconque des revendications précédentes, disposée à l'intérieur de l'aéronef.

10. Procédé d'étalonnage d'une unité d'éclairage à DEL intérieure d'aéronef (2) ayant au moins une DEL (6) et un couvre-lentille (12) disposé sur l'au moins une DEL (6), le couvre-lentille (12) ayant un côté proximal (12a) faisant face à l'au moins une DEL (6) et un côté distal (12b) formant une partie extérieure de l'unité d'éclairage à DEL intérieure d'aéronef (2), le couvre-lentille (12) étant fabriqué à partir d'un matériau de couvre-lentille présentant des propriétés de transfert de lumière spécifiques au matériau et l'unité d'éclairage à DEL intérieure d'aéronef (2) comprenant au moins l'un d'un filtre de luminosité (8), d'un filtre de couleur et d'un filtre combiné de luminosité et de couleur, disposés entre l'au moins une DEL (6) et le couvre-lentille (12), le procédé comprenant les étapes :
de mesure d'une performance d'éclairage initiale de l'unité d'éclairage à DEL intérieure d'aéronef (2), et
en fonction de ladite étape de mesure de la performance d'éclairage initiale, la fourniture au côté distal (12b) du couvre-lentille (12) d'un motif de points (16), chacun des motifs de points (16) modifiant localement les propriétés de transfert de lumière spécifiques au matériau du couvre-lentille (12), dans lequel le motif de points (16) consiste en des points blancs, lorsqu'ils sont vus de l'extérieur de l'unité d'éclairage à DEL intérieure d'aéronef (2).

11. Procédé selon la revendication 10, dans lequel l'étape de fourniture au côté distal (12b) du couvre-lentille (12) du motif de points (16) comprend :
la détermination d'un écart entre les performances d'éclairage initiales et les performances d'éclairage souhaitées, et
la sélection d'une densité du motif de points (16) de manière à compenser l'écart.
